# EUROPÄISCHE PATENTSCHRIFT

(11) **EP 0 838 773 B1**
(45) Veröffentlichungstag und Bekanntmachung des Hinweises auf die Patenterteilung: **11.02.2004**
(21) Anmeldenummer: 97115525.4
(22) Anmeldetag: 08.09.1997
(51) Int. Cl.: G06F 17/50

(54) **Verfahren und Vorrichtung zur Handhabung von Kennzeichnungsdaten einer Mehrzahl von Komponenten eines Produktes**
Method and apparatus for handling the serial numbers of multiple components of a product
Procédé et dispositif pour manipuler les nombres d'identification de plusieurs composants d'un produit

(30) Priorität: 28.10.1996 DE 19644680
(43) Veröffentlichungstag der Anmeldung: 29.04.1998
(73) Patentinhaber: Volkswagen Aktiengesellschaft, 38436 Wolfsburg (DE)
(72) Erfinder: Ritter, Albert, Dipl.-Ing., 38518 Gifhorn (DE); Homann, Hansjürgen, 38442 Wolfsburg (DE); Suschinski, Burghard, 38108 Braunschweig (DE)
(74) Vertreter: Zucker, Volker, Dipl.-Ing.

(56) Entgegenhaltungen:
- EP-A- 0 457 706
- EP-A- 0 481 907
- US-A- 5 201 046
- "REPRESENTING BILL OF MATERIAL AND WHERE-USED PRODUCT STRUCTURE DATA USING AN ISAM DATA BASE WITH TWO INDICES" IBM TECHNICAL DISCLOSURE BULLETIN, Bd. 31, Nr. 6, 1.November 1988, Seiten 355-360, XP000118831

## Beschreibung

Die Erfindung betrifft eine Vorrichtung zur Handhabung von Kennzeichnungsdaten von Komponenten eines Produktes, wobei die Komponenten Module, bestehend aus mindestens zwei Einzelteilen, oder Einzelteile darstellen, welche mindestens eine Verarbeitungseinrichtung, eine Speichereinrichtung, eine Einrichtung zur Eingabe der Kennzeichnungsdaten und eine Einrichtung zur Ausgabe von Kennzeichnungsdaten umfaßt, sowie ein Verfahren zur Handhabung von Kennzeichnungsdaten von Komponenten eines Produktes, bei dem die Kennzeichnungsdaten über eine Einrichtung zur Eingabe der Kennzeichnungsdaten eingegeben und in einer einer Verarbeitungseinrichtung zugeordneten Speichereinrichtung abgelegt werden.

Die elektronische Verarbeitung von Produkt- oder Kennzeichnungsdaten gewinnt mit der immer stärker werdenden betrieblichen und überbetrieblichen datentechnischen Kopplung von Entwicklung, Konstruktion, Logistik und Fertigung zunehmend an Bedeutung. Dafür verwendbare Stücklistenorganisationen in Form einer Baumstruktur mit Knoten und Knotenverbindungen sind aus der Druckschrift Angewandte Informatik" 9/81, Stücklistenorganisation bei einer großen Variantenanzahl, bekannt Die dabei verwendeten Knoten repräsentieren Erzeugnisse, Baugruppen oder Einzelteile. Die gerichteten und mit Mengenangaben bewerteten Knotenverbindungen geben die Strukturierung an. In einer ersten beschriebenen Organisationsstruktur wird jeder Variante des Produktes und in einer untergeordneten Ebene jeder Baugruppe und jedem Einzelteil ein Knoten zugeordnet. Die Knoten der Einzelteile und Baugruppen wiederum sind über die Knotenverbindungen der jeweiligen Produktvariante zugeordnet. Geht ein Einzelteil oder eine Baugruppe in mehrere Produktvarianten ein, weist der jeweilige Knoten einzelne Knotenverbindungen zu jeder dieser Produktvarianten auf. Hierbei ergeben sich Speicherungs- und Rechercheprobleme, wenn die Zahl der zu verwaltenden Erzeugnisstrukturen sehr groß ist. Dies tritt insbesondere dann ein, wenn ein Produkt in vielen Varianten gefertigt wird, wie es beispielsweise im Kraftfahrzeugbau der Fall ist.

Eine zweite in der Druckschrift beschriebene Stücklistenorganisation besteht darin, daß nicht die Erzeugnisstruktur beschrieben wird, sondern zusammengefaßt die Struktur der in einer Variantenreihe enthaltenen Erzeugnisse. Dabei werden vier Knotentypen verwendet. Der Teileknoten ist durch ein Erzeugnis, eine Baugruppe oder ein Einzelteil bestimmt. Des weiteren ist der Konjunktivknoten vorgesehen, bei dem alle durch die direkt untergeordneten Knoten unmittelbar oder mittelbar bestimmten Teile in das Erzeugnis eingehen. Bei dem Alternativknoten gehen nur die durch genau einen direkt untergeordneten Knoten bestimmten Teile in das Erzeugnis ein. Der sogenannte "leere" Knoten ist durch ein nicht vorhandenes Teil bestimmt. Durch die Verwendung der Pseudoknoten, Konjunktiv-, Altemativ- und "leerer" Knoten, liegt auch hier ein Speicherproblem bei Produkten mit einer großen Varianz oder Produkten, die aus vielen Einzelteilen bestehen, vor. Des weiteren liegt ein Nachteil darin, daß nur eine einstufige Komponenten-Produktbeziehung besteht.

Eine Vorrichtung nach dem Oberbegriff des Anspruchs 1 bzw. ein Verfahren nach dem Oberbegriff des Anspruchs 7 sind dem Prinzip nach durch US-A-5,201,046 bekannt.

Der Erfindung liegt die Aufgabe zugrunde, eine Vorrichtung und ein Verfahren zur Handhabung von Kennzeichnungsdaten von Komponenten eines Produktes zu schaffen, wobei der Bedarf an Speicherkapazität so gering wie möglich gehalten wird und eine Kontrolle auf Vollständigkeit der zu einem Produkt gehörenden Komponenten auf einfache Weise möglich ist.

Die Aufgabe wird durch eine Vorrichtung gemäß Patentanspruch 1 und ein Verfahren nach Patentanspruch 7 gelöst. Vorteilhafte Aus- und Weiterbildungen sind in den Unteransprüchen dargestellt.

Erfindungsgemäß sind die in die Vorrichtung eingegebenen Kennzeichnungsdaten der Komponenten in der Speichereinrichtung hierarchisch in Ebenen abgelegt. Die Ebenen weisen Knoten auf, die jeweils die Kennzeichnungsdaten einer Komponente, das heißt eines Moduls oder eines Einzelteils enthalten. Als Modul ist hier auch das Produkt zu verstehen. Dabei sind mehrere Knoten einer untergeordneten Ebene einem Knoten mit Kennzeichnungsdaten eines Moduls einer nächsthöheren Ebene zugewiesen, wobei der Knoten der nächsthöheren Ebene durch die Gesamtheit der dem Knoten zugeordneten Knoten der untergeordneten Ebene vollständig beschrieben ist.

Die Zuordnung der Knoten zweier benachbarter Ebenen erfolgt über Verknüpfungsoperatoren, wobei die Verknüpfungsoperatoren die Anzahl der benötigten Komponenten eines Knotens einer Ebene im Modul der nächsthöheren Ebene beinhalten. Die Speicherung der Knoten erfolgt dabei in Teiledateien, die der Verknüpfungsoperatoren in Strukturdateien.

Bei Produkten mit mehreren Varianten umfaßt, wie es beispielsweise bei Kraftfahrzeugen der Fall ist, einer oder mehrere der Knoten Kennzeichnungsdaten mehrerer Varianten seiner Komponente. Außerdem kann einer oder mehrere der Knoten Kennzeichnungsdaten einer "leeren" Komponentenvariante enthalten. Diese Kennzeichnungsdaten dienen ausschließlich dazu, die Variante existiert nicht" zuzulassen.

Die Kennzeichnungsdaten der Komponenten einer Ebene enthalten Merkmalsdaten der Komponenten zumindest der nächsthöheren Ebene, denen sie über die Verknüpfungsoperatoren zugeordnet sind. Ober die Merkmalsdaten sind die Komponenten eines Produktes oder einer Produktvariante in der Verarbeitungseinrichtung verknüpfbar, damit recherchierbar und über die Einrichtung zur Ausgabe der Kennzeichnungsdaten teilweise oder in ihrer Gesamtheit ausgebbar.

Nachfolgend wird die Erfindung anhand von Ausführungsbeispielen näher beschrieben. Die zugehörigen Zeichnungen zeigen:
- Figur 1: ein Blockschaltbild der erfindungsgemäßen Vorrichtung,
- Figur 2: einen Strukturaufbau von abgespeicherten Kennzeichnungsdaten der Produktkomponenten,
- Figur 3: einen Ausschnitt aus einem abgespeicherten Strukturaufbau der Kennzeichnungsdaten eines Produktes und seiner Komponenten mit mehreren Varianten und
- Figur 4: Zusammenhänge zwischen zwei Knoten benachbarter Ebenen.

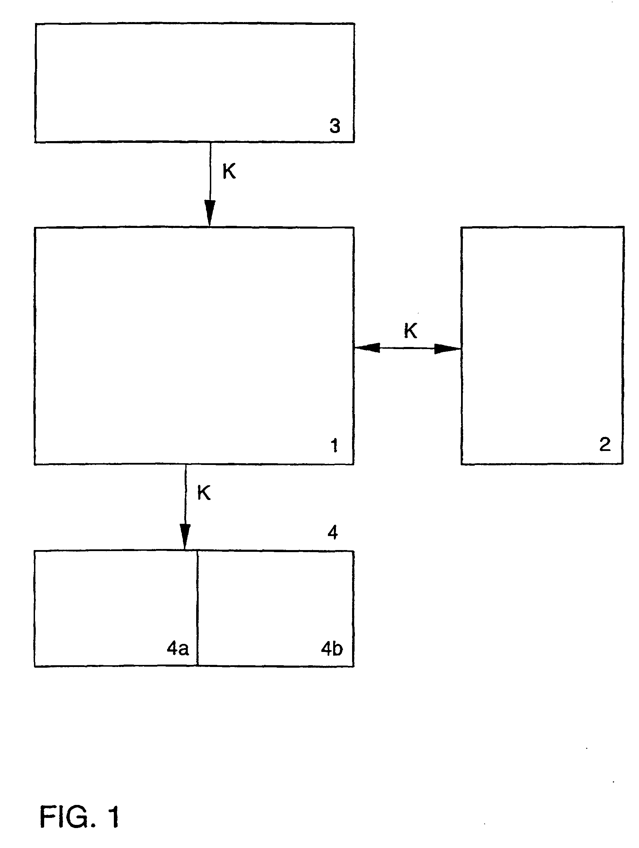

Die in Figur 1 dargestellte Vorrichtung zur Handhabung von Kennzeichnungsdaten der Komponenten eines Produktes faßt eine elektronische Verarbeitungseinrichtung 1, eine Einrichtung 3 zur Eingabe von Kennzeichnungsdaten k der Komponenten bzw. des Produktes in die Verarbeitungseinrichtung 1, eine der Verarbeitungseinrichtung zugeordnete Speichereinrichtung 2 zur strukturierten Abspeicherung der Kennzeichnungsdaten k. Ober die Verarbeitungseinrichtung 1 werden nach Abfragevorgaben, die über die Einrichtung 3 der Verarbeitungseinrichtung zugeführt werden können, die gewünschten Kennzeichnungsdaten ausgewählt und über die Einrichtung 4 zur Ausgabe der recherchierten Kennzeichnungsdaten kᵣ ausgegeben. Die Einrichtung 4 kann dabei einen Drucker 4a und/oder einen Monitor 4b zum Anzeigen der Kennzeichnungsdaten aufweisen.

Die Verarbeitungseinrichtung 1 kann des weiteren in einem Datennetz integriert werden, wobei sie dann in eine Servereinheit mit der Speichereinrichtung 2 und dezentrale Verarbeitungseinrichtungen mit den Einrichtungen 3 und 4 zur Ein- und Ausgabe der Kennzeichnungsdaten aufgeteilt ist.

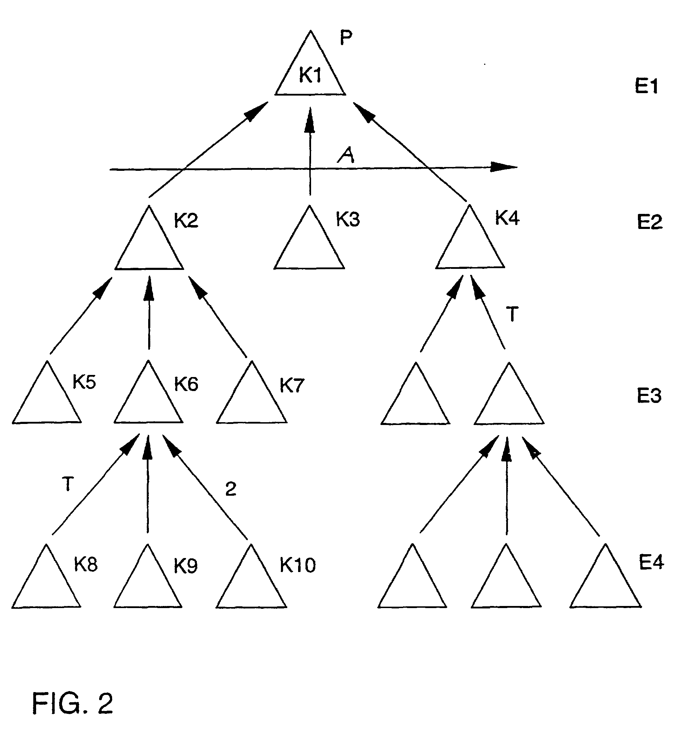

In Figur 2 ist ein Beispiel eines Strukturaufbaus der Abspeicherung der Kennzeichnungsdaten von zu einem Produkt gehörigen Komponenten gezeigt. Bei dem dargestellten Strukturaufbau sind die Kennzeichnungsdaten der aus Modulen oder Einzelteilen bestehenden Komponenten in Ebenen E1 bis E4 abgespeichert, wobei in der höchsten Ebene E1 die Kennzeichnungsdaten des Produktes P selbst abgelegt sind. Die Ebenen E1 bis E4 weisen Knoten K1 - K 10 auf, die jeweils die Kennzeichnungsdaten einer Komponente beinhalten. Dabei können die Komponenten sowohl Einzelteile, Module, bestehend aus mindestens zwei Einzelteilen, oder das Produkt P selbst darstellen.

Das Produkt P besteht in seiner letzten Aggregierungsebene E2 aus drei Komponenten, deren Kennzeichnungsdaten in den Knoten K2 bis K4 abgelegt sind. Der Knoten K3 beinhaltet dabei die Kennzeichnungsdaten eines Einzelteils und die Knoten K2 und K4 die Kennzeichnungsdaten von Modulen. Das Modul des Knotens K2 besteht wiederum genau aus drei Komponenten, deren Kennzeichnungsdaten in den Knoten K5 bis K7 der untergeordneten Ebene E3 abgelegt sind, wobei auch hier der Knoten K6 ein Modul kennzeichnet, das aus drei durch die in den Knoten K8 bis K10 der Ebene E4 beschriebenen unterschiedlichen Einzelteilen besteht. Die Zuordnung der Knoten einer untergeordneten Ebene E2 bis E4 zu der nächsthöheren Ebene E1 bis E3 erfolgt über die Verknüpfungsoperatoren T, die die Anzahl der Komponenten der untergeordneten Ebene im Knoten der nächsthöheren Ebene beinhalten. So wird beispielsweise das durch den Knoten K10 gekennzeichnete Einzelteil zweimal in dem durch den Knoten K6 gekennzeichneten Modul benötigt.

Die Ebenen E2 bis E4 stellen vorteilhafterweise Montageabschnitte bzw. Zulieferebenen dar, wodurch beispielsweise ein genauer Überblick über die Anlieferung der Komponenten zu der jeweiligen Montagestufe gegeben ist Ober die Reihenfolge der Knoten innerhalb der Aggregierungsebene E2 kann außerdem der Montageablauf des Produktes definiert werden. In der Figur 2 ist der Montageablauf durch den Pfeil A gekennzeichnet.

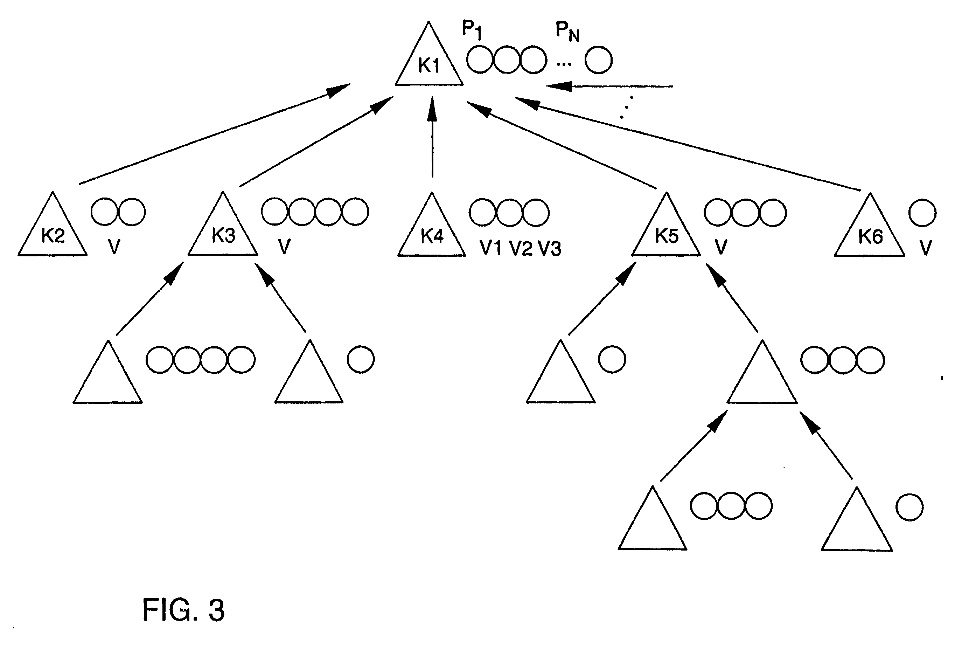

Figur 3 zeigt einen Ausschnitt des Strukturaufbaus der Kennzeichnungsdaten eines Produktes, das mehrere Varianten P1 bis PN besitzt. Das Produkt, im Ausführungsbeispiel ein Kraftfahrzeug, besteht aus den Varianten P1 bis PN und ist durch den Knoten K1 in der Ebene E1 gekennzeichnet. Jede dieser Varianten P1 bis PN weist zumindest die Komponenten der Knoten K2 bis K6 auf, wobei die Knoten K2, K4 und K6 Einzelteile und die Knoten K3 und K5 Module kennzeichnen. Außerdem beinhalten die Knoten K2 bis K5 die Kennzeichnungsdaten mehrerer Varianten V ihrer Komponenten, durch deren Kombination die Varianten P1 bis PN des Produktes festgelegt sind. Im weiteren soll die Variantenstrukturierung am Knoten K4 näher dargestellt werden. Der Knoten K4 beinhaltet die Kennzeichnungsdaten der Varianten V1 und V2 eines Audiogerätes des Kraftfahrzeuges sowie die Kennzeichnungsdaten eines nicht vorhandenen Radios V3 für das Produkt Kraftfahrzeug. Damit ergibt sich aus dieser Komponente eine Aufteilung des Produktes in drei Varianten. In Kombination mit den Varianten V der weiteren Knoten K2, K3, K5, K6 der Ebene E2 ergeben sich sämtliche Varianten P1 bis PN des Produktes, wobei die Komponenten Varianten der Knoten K3 und K5, wiederum aus Komponenten mit verschiedenen Varianten bestehen.

Zur Auswahl der Komponentenvariante nach der Festlegung der Produktvariante weisen die Kennzeichnungsdaten der Komponenten Merkmalsdaten der jeweiligen Produktvariante P1 bis PN auf, nach denen die Auswahl in der Verarbeitungseinrichtung erfolgt. Gleiches gilt natürlich für die Komponenten in den Ebenen E2, E3 und E3, E4.

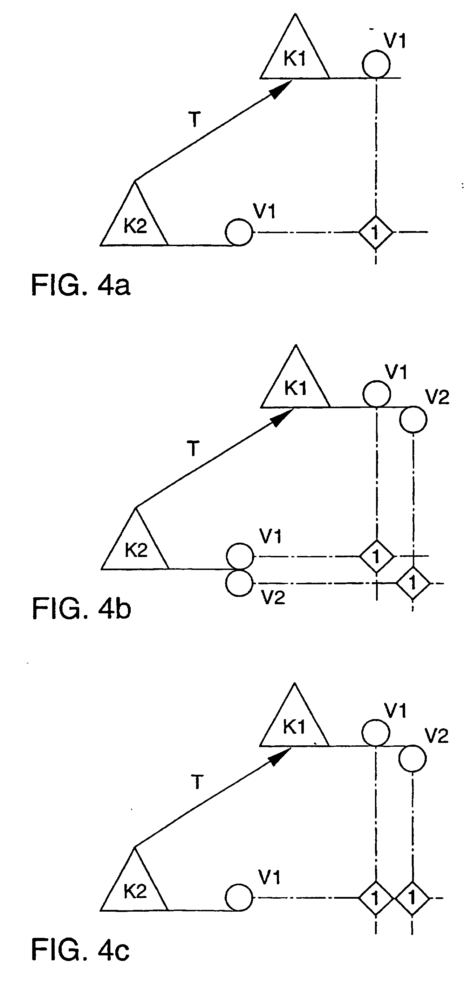

In den Figuren 4a bis 4c sind mögliche Zusammenhänge zwischen zwei über einen Verknüpfungsoperator T zugeordnete Knoten K1 und K2 zweier benachbarter Ebenen dargestellt. Der Knoten K1 steht dabei für ein Produkt oder ein Modul und der Knoten K2 beinhaltet die Kennzeichnungsdaten eines Moduls oder eines Einzelteils. In Figur 4a weist der Knoten K2 die Kennzeichnungsdaten einer einzigen Komponentenvariante V1 auf, die die Variante V1 des Knotens K1 erzeugt. In Figur 4b beinhaltet der Knoten K2 die Kennzeichnungsdaten der Varianten V1 und V2, die die Modul- oder Produktvarianten V1 und V2 des Knotens K1 bilden. Der Knoten K1 der Figur 4c besitzt die Modul- oder Produktvarianten V1 und V2, in welche jeweils die Variante V1 des Moduls oder des Einzelteils des Knotens K2 eingeht.

### BEZUGSZEICHENLISTE

- 1: Verarbeitungseinrichtung
- 2: Speichereinrichtung
- 3: Eingabeeinrichtung
- 4: Ausgabeeinrichtung
- 4a: Drucker
- 4b: Monitor
- k: Kennzeichnungsdaten
- kᵣ: recherchierte Kennzeichnungsdaten
- E1 - E4: Ebene
- P: Produkt
- P1 - PN: Produktvariable
- K, K1 - K10: Knoten
- T: Verknüpfungsoperator
- V, V1 - V3: Komponentenvariante

## Patentansprüche

1. Vorrichtung zur Handhabung von Kennzeichnungsdaten einer Mehrzahl von Komponenten eines Produktes, wobei die Komponenten Module, bestehend aus mindestens zwei Einzelteilen, oder Einzelteile darstellen, welche mindestens eine elektronische Verarbeitungseinrichtung (1), eine Speichereinrichtung (2), eine Einrichtung (3) zur Eingabe der Kennzeichnungsdaten und eine Einrichtung (4) zur Ausgabe von Kennzeichnungsdaten umfasst, wobei die über die Einrichtung (3) zur Eingabe eingegebenen Kennzeichnungsdaten (k) in der Speichereinrichtung (2) hierarchisch in Ebenen (E1 - E4) ablegbar sind, die Ebenen Knoten (K) aufweisen, die jeweils die Kennzeichnungsdaten (k) einer Komponente enthalten, mehrere Knoten einer untergeordneten Ebene (E2 - E4) einem Knoten (K) mit Kennzeichnungsdaten (k) eines Moduls einer übergeordneten Ebene (E1 - E3) zugewiesen sind und jeder Knoten einer Ebene (E1 - E3) mit Kennzeichnungsdaten (k) eines Moduls durch die Gesamtheit der dem Knoten (K) zugeordneten Knoten (K) der untergeordneten Ebene (E2 - E4) vollständig beschrieben ist, wobei Verknüpfungsoperatoren (T) vorgesehen sind, die die Zuordnung der Knoten (K) zweier benachbarter Ebenen (E1 - E4) herstellen,
**dadurch gekennzeichnet, dass**
die Verknüpfungsoperatoren (T) die Anzahl der benötigten Komponenten eines Knotens (K) einer Ebene (E2 - E4) in der nächst höheren Ebene (E1 - E3) beinhalten.

2. Vorrichtung nach Anspruch 1, **dadurch gekennzeichnet, dass** das Produkt (P) mehrere Produktvarianten (P1 - PN) aufweist und mindestens einer der Knoten (K) Kennzeichnungsdaten (k) mehrerer Varianten (V) der Komponente umfasst.

3. Vorrichtung nach Anspruch 2, **dadurch gekennzeichnet, dass** mindestens einer der Knoten (K) Kennzeichnungsdaten (k) einer "leeren" Komponentenvariante (V3) enthält.

4. Vorrichtung nach einem der Ansprüche 1 bis 3, **dadurch gekennzeichnet, dass** die Kennzeichnungsdaten (k) der Komponenten einer Ebene (E2 - E4) Merkmalsdaten der Komponenten zumindest der nächsthöheren Ebene (E1 - E3 ) aufweisen, denen sie über die Verknüpfungsoperatoren (T) zugeordnet sind.

5. Vorrichtung nach Anspruch 4, **dadurch gekennzeichnet, dass** die Kennzeichnungsdaten (k) der Komponenten eines Produktes oder einer Produktvariante mittels der Merkmalsdaten in der Verarbeitungseinrichtung (1) verknüpfbar und über die Einrichtung (4) zur Ausgabe der Kennzeichnungsdaten (kᵣ) teilweise oder in ihrer Gesamtheit ausgebbar sind.

6. Vorrichtung nach einem der Ansprüche 1 bis 5, **dadurch gekennzeichnet, dass** das Produkt (P) ein Kraftfahrzeug ist.

7. Verfahren zur Handhabung von Kennzeichnungsdaten von Komponenten eines Produktes, wobei die Komponenten Module, bestehend aus mindestens zwei Einzelteilen, oder Einzelteile darstellen, bei dem die Kennzeichnungsdaten über eine Einrichtung (3) zur Eingabe der Kennzeichnungsdaten in eine Verarbeitungseinrichtung (1) eingegeben und in einer der Verarbeitungseinrichtung zugeordneten Speichereinrichtung (2) abgelegt werden, die Kennzeichnungsdaten (k) in der Speichereinrichtung (2) hierachisch in Ebenen (E1 -E4) abgelegt werden, die Ebenen Knoten (K) aufweisen, die jeweils die Kennzeichnungsdaten einer Komponente enthalten, mehrere Knoten (K) einer untergeordneten Ebene (E2 - E4) einem Knoten (K) einer übergeordneten Ebene (E1 - E3) mit Kennzeichnungsdaten eines Moduls zugewiesen werden und jeder Knoten (K) einer Ebene (E1 - E3) mit Kennzeichnungsdaten eines Moduls durch die Gesamtheit der dem Knoten (K) zugeordneten Knoten (K) der untergeordneten Ebene (E2 - E4) vollständig beschrieben wird, die Zuordnung der Knoten (K) zweier benachbarter Ebenen über Verknüpfungsoperatoren (T) hergestellt wird,
**dadurch gekennzeichnet, dass**
die Verknüpfungsoperatoren (T) die Anzahl der benötigten Komponenten eines Knotens (K) einer Ebene (E2 - E4) in der nächst höheren Ebene (E1 - E3) beinhalten.

8. Verfahren nach Anspruch 7, **dadurch gekennzeichnet, dass** das Produkt (P) mehrere Produktvarianten (P1 - PN) aufweist und mindestens einer der Knoten (K) Kennzeichnungsdaten (k) mehrerer Varianten (V) der Komponente umfasst.

9. Verfahren nach Anspruch 8, **dadurch gekennzeichnet, dass** mindestens einer der Knoten (K) Kennzeichnungsdaten (k) einer "leeren" Komponentenvariante (V3) enthält.

10. Verfahren nach einem der Ansprüche 7 bis 9, **dadurch gekennzeichnet, dass** die Kennzeichnungsdaten (k) der Komponenten einer Ebene (E2 - E4) Merkmalsdaten der Komponenten zumindest der nächst höheren Ebene (E1 - E3) aufweisen, denen sie über die Verknüpfungsoperatoren (T) zugeordnet sind.

11. Verfahren nach Anspruch 10, **dadurch gekennzeichnet, dass** die Komponenten eines Produktes (P) oder einer Produktvariante (P1 - PN) mittels der Merkmalsdaten in der Verarbeitungseinrichtung (1) verknüpfbar sind.

## Claims

1. Device for handling identification data of a multiplicity of components of a product, the components constituting modules, composed of at least two individual parts, or individual parts, which device comprises at least an electronic processing device (1), a storage device (2), a device (3) for inputting the identification data and a device (4) for outputting identification data, the identification data (k) which is input by means of the inputting device (3) being able to be hierarchically stored on levels (E1 - E4) in the storage device (2), the levels having nodes (K) which each contain the identification data (k) of a component, a plurality of nodes of a subordinate level (E2 - E4) being assigned to a node (K) with identification data (k) of a module of a superordinate level (E1 - E3), and each node of a level (E1 - E3) being completely described using identification data (k) of a module by means of the entirety of the nodes (K) of the subordinate level (E2 - E4) which are assigned to the node (K), and logic operators (T) being provided which bring about the assignment of the nodes (K) of two adjacent levels (E1 - E4), **characterized in that** the logic operators (T) include the number of required components of a node (K) of a level (E2 - E4) in the next highest level (E1 - E3).

2. Device according to Claim 1, **characterized in that** the product (P) has a plurality of product variants (P1 - PN), and at least one of the nodes (K) comprises identification data (k) of a plurality of variants (V) of the component.

3. Device according to Claim 2, **characterized in that** at least one of the nodes (K) contains identification data (k) of an "empty" component variant (V3).

4. Device according to one of Claims 1 to 3, **characterized in that** the identification data (k) of the components of a level (E2 - E4) have feature data of the components of at least the next highest level (E1 - E3) to which components they are assigned by means of the logic operators (T).

5. Device according to Claim 4, **characterized in that** the identification data (k) of the components of a product or of a product variant can be logically linked by means of the feature data in the processing device (1), and can be output partially or in their entirety by means of the device (4) for outputting the identification data (kᵣ).

6. Device according to one of Claims 1 to 5, **characterized in that** the product (P) is a motor vehicle.

7. Method for handling identification data of components of a product, the components constituting modules, composed of at least two individual parts, or individual parts, in which method the identification data is input into a processing device (1) by means of a device (3) for inputting the identification data, and said data is stored in a storage device (2) which is assigned to the processing device, the identification data (k) being stored hierarchically in levels (E1 - E4) in the storage device (2), the levels having nodes (K) which each contain the identification data of a component, a plurality of nodes (K) of a subordinate level (E2 - E4) being assigned to a node (K) of a superordinate level (E1 - E3) with identification data of a module, and each node (K) of a level (E1 - E3) being completely described using identification data of a module by means of the entirety of the nodes (K) of the subordinate level (E2 - E4) which are assigned to the node (K), and the assignment of the nodes (K) of two adjacent levels being brought about by means of logic operators (T), **characterized in that** the logic operators (T) include the number of required components of a node (K) of a level (E2 - E4) in the next highest level (E1 - E3).

8. Method according to Claim 7, **characterized in that** the product (P) has a plurality of product variants (P1 - PN), and at least one of the nodes (K) comprises identification data (k) of a plurality of variants (V) of the component.

9. Method according to Claim 8, **characterized in that** at least one of the nodes (K) contains identification data (k) of an "empty" component variant (V3).

10. Method according to one of Claims 7 to 9, **characterized in that** the identification data (k) of the components of a level (E2 - E4) comprises feature data of the components of at least the next highest level (E1 - E3) to which it is assigned by means of the logic operators (T).

11. Method according to Claim 10, **characterized in that** the components of a product (P) or of a product variant (P1 - PN) can be logically linked by means of the feature data in the processing device (1).

## Revendications

1. Dispositif de manipulation de données d'identification de plusieurs composants d'un produit, les composants représentant des modules, constitués d'au moins deux pièces constitutives, ou des pièces constitutives, lequel dispositif comprend au moins un dispositif de traitement électronique (1), un dispositif de mémorisation (2), un dispositif (3) pour l'entrée des données d'identification et un dispositif (4) pour la sortie de données d'identification, les données d'identification (k) entrées par l'intermédiaire du dispositif (3) d'entrée pouvant être stockées en niveaux hiérarchiques (E1 à E4) dans le dispositif de mémorisation (2), les niveaux comportant des noeuds (K) qui contiennent à chaque fois les données d'identification (k) d'un composant, plusieurs noeuds d'un niveau subordonné (E2 à E4) étant attribués à un noeud (K) contenant des données d'identification (k) d'un module d'un niveau supérieur (E1 à E3) et chaque noeud d'un niveau (E1 à E3) qui contient des données d'identification (k) d'un module étant entièrement décrit par la totalité des noeuds (K), attribués au noeud (K), du niveau subordonné (E2 à E4), des opérateurs combinatoires (T) étant prévus pour spécifier l'attribution des noeuds (K) de deux niveaux voisins (E1 à E4),
**caractérisé en ce que**
les opérateurs combinatoires (T) contiennent le nombre des composants nécessaires d'un noeud (K) d'un niveau (E2 à E4) dans le niveau immédiatement supérieur (E1 à E3).

2. Dispositif selon la revendication 1, **caractérisé en ce que** le produit (P) comporte plusieurs variantes de produit (P1 à PN) et **en ce qu'**au moins l'un des noeuds (K) comprend des données d'identification (k) de plusieurs variantes (V) du composant.

3. Dispositif selon la revendication 2, **caractérisé en ce qu'**au moins l'un des noeuds (K) contient des données d'identification (k) d'une variante de composant "vide" (V3).

4. Dispositif selon l'une des revendications 1 à 3, **caractérisé en ce que** les données d'identification (k) des composants d'un niveau (E2 à E4) comportent des données caractéristiques des composants au moins du niveau immédiatement supérieur (E1 à E3) auxquelles elles sont associées par l'intermédiaire des opérateurs combinatoires (T).

5. Dispositif selon la revendication 4, **caractérisé en ce que** les données d'identification (k) des composants d'un produit ou d'une variante de produit peuvent être combinées au moyen des données caractéristiques dans le dispositif de traitement (1) et peuvent être délivrées en sortie partiellement ou dans leur totalité par l'intermédiaire du dispositif (4) pour la sortie des données d'identification (kᵣ).

6. Dispositif selon l'une des revendications 1 à 5, **caractérisé en ce que** le produit (P) est un véhicule automobile.

7. Procédé de manipulation de données d'identification de composants d'un produit, les composants représentant des modules, constitués d'au moins deux pièces constitutives, ou des pièces constitutives, selon lequel les données d'identification sont entrées par l'intermédiaire d'un dispositif (3) pour l'entrée des données d'identification dans un dispositif de traitement (1) et sont stockées dans un dispositif de mémorisation (2) associé au dispositif de traitement, selon lequel les données d'identification (k) sont stockées en niveaux hiérarchiques (E1 à E4) dans le dispositif de mémorisation (2), selon lequel les niveaux comportent des noeuds (K) qui contiennent à chaque fois les données d'identification d'un composant, selon lequel plusieurs noeuds (K) d'un niveau subordonné (E2 à E4) sont attribués à un noeud (K) d'un niveau supérieur (E1 à E3) contenant des données d'identification d'un module et selon lequel chaque noeud (K) d'un niveau (E1 à E3) contenant des données d'identification d'un module est entièrement décrit par la totalité des noeuds (K), attribués au noeud (K), du niveau subordonné (E2 à E4) et selon lequel l'attribution des noeuds (K) de deux niveaux voisins est spécifiée par l'intermédiaire d'opérateurs combinatoires (T),
**caractérisé en ce que**
les opérateurs combinatoires (T) contiennent le nombre des composants nécessaires d'un noeud (K) d'un niveau (E2 à E4) dans le niveau immédiatement supérieur (E1 à E3).

8. Procédé selon la revendication 7, **caractérisé en ce que** le produit (P) comporte plusieurs variantes de produit (P1 à PN) et **en ce qu'**au moins l'un des noeuds (K) comprend des données d'identification (k) de plusieurs variantes (V) du composant.

9. Procédé selon la revendication 8, **caractérisé en ce qu'**au moins l'un des noeuds (K) contient des données d'identification (k) d'une variante de composant "vide" (V3).

10. Procédé selon l'une des revendications 7 à 9, **caractérisé en ce que** les données d'identification (k) des composants d'un niveau (E2 à E4) comportent des données caractéristiques des composants au moins du niveau immédiatement supérieur (E1 à E3) auxquelles elles sont associées par l'intermédiaire des opérateurs combinatoires (T).

11. Procédé selon la revendication 10, **caractérisé en ce que** les composants d'un produit (P) ou d'une variante de produit (P1 à PN) peuvent être combinés au moyen des données caractéristiques dans le dispositif de traitement (1).
